(19) Europäisches Patentamt
European Patent Office
Office européen des brevets

(11) **EP 4 199 345 A1**

(12) **DEMANDE DE BREVET EUROPEEN**

(43) Date de publication:
**21.06.2023 Bulletin 2023/25**

(21) Numéro de dépôt: **22213560.0**

(22) Date de dépôt: **14.12.2022**

(51) Classification Internationale des Brevets (IPC):
*H02P 27/06* (2006.01)  *H02M 7/42* (2006.01)
*H02M 1/00* (2006.01)  *G01R 31/42* (2006.01)
*G01R 19/00* (2006.01)  *H02M 1/32* (2007.01)
*G01R 19/165* (2006.01)  *G01R 19/12* (2006.01)
*H02M 7/5387* (2007.01)  *G01R 1/20* (2006.01)

(52) Classification Coopérative des Brevets (CPC):
**G01R 31/42; G01R 19/12; G01R 19/16571;
H02M 1/0009; H02M 1/32; H02M 7/5387;**
G01R 1/203; G01R 31/52

(84) Etats contractants désignés:
**AL AT BE BG CH CY CZ DE DK EE ES FI FR GB
GR HR HU IE IS IT LI LT LU LV MC ME MK MT NL
NO PL PT RO RS SE SI SK SM TR**
Etats d'extension désignés:
**BA**
Etats de validation désignés:
**KH MA MD TN**

(30) Priorité: **15.12.2021 FR 2113576**

(71) Demandeur: **Commissariat à l'énergie atomique
et aux énergies alternatives
75015 Paris (FR)**

(72) Inventeurs:
• **LANNELUC, Charley
38054 GRENOBLE cedex 9 (FR)**
• **PERICHON, Pierre
38054 GRENOBLE cedex 9 (FR)**
• **FERNANDEZ, Eric
38054 GRENOBLE cedex 9 (FR)**

(74) Mandataire: **Lavoix
2, place d'Estienne d'Orves
75441 Paris Cedex 09 (FR)**

(54) **DISPOSITIF ET PROCÉDÉ DE SURVEILLANCE D'UN CONVERTISSEUR D'ÉNERGIE ÉLECTRIQUE, SYSTÈME DE CONVERSION D'ÉNERGIE ÉLECTRIQUE ASSOCIÉ**

(57) Dispositif de surveillance (20) configuré pour surveiller un convertisseur (10) comprenant des première (30) et deuxième (32) bornes d'entrée, deux bornes de sortie (34), une première branche de filtrage (36) connectée entre les bornes d'entrée, une deuxième branche de filtrage (38) connectée en parallèle de la première branche, deux branches de commutation (40) connectées en parallèle de la deuxième branche, chaque branche de commutation comportant deux demi-branches de commutation (60) connectées en série et reliées entre elles en un point intermédiaire (62) formant borne de sortie.

Le dispositif de surveillance (20) comprend une impédance de détection (45) configurée pour être connectée entre les première et deuxième branches, et un module de détection (50) configuré pour comparer la tension ($V_D$) aux bornes de l'impédance de détection avec un seuil prédéfini, puis pour générer un signal de détection dès que ladite tension est supérieure audit seuil.

FIG.1

**Description**

La présente invention concerne un dispositif de surveillance d'un convertisseur d'énergie électrique.

Le convertisseur d'énergie électrique est apte à convertir une tension d'entrée en une tension de sortie et comprend une première et une deuxième bornes d'entrée aptes à recevoir la tension d'entrée, au moins deux bornes de sortie aptes à délivrer la tension de sortie, une première branche de filtrage connectée entre les bornes d'entrée, une deuxième branche de filtrage connectée en parallèle de la première branche de filtrage, au moins deux branches de commutation connectées en parallèle de la deuxième branche de filtrage, chaque branche de filtrage comportant un condensateur, chaque branche de commutation comportant deux interrupteurs reliés en un point milieu, le point milieu de chaque branche de commutation formant alors une borne de sortie respective.

L'invention concerne également un système de conversion d'énergie électrique, comprenant un tel convertisseur d'énergie électrique et un tel dispositif de surveillance du convertisseur d'énergie électrique.

L'invention concerne aussi un procédé de surveillance d'un tel convertisseur d'énergie électrique.

L'invention concerne également l'utilisation d'un tel dispositif de surveillance pour surveiller un tel convertisseur d'énergie électrique.

L'invention concerne le domaine des systèmes électroniques de conversion d'énergie électrique, notamment des systèmes de conversion en une énergie électrique alternative, notamment les systèmes de conversion continu-alternatif, également appelés onduleurs ou encore systèmes de conversion DC-AC (de l'anglais *Direct Current - Alternating Current*). De tels systèmes de conversion sont notamment utilisés pour l'alimentation de moteurs électriques.

Des composants de puissance de nouvelle génération, basés sur des matériaux semi-conducteur à large bande, également dit « grand gap » sont de plus en plus utilisés. Ces matériaux à large bande sont des matériaux dont la largeur de la bande interdite, entre la bande de valence et la bande de conduction, est plus importante que celle du silicium dont on atteint les limites physiques.

Parmi ces matériaux à large bande, le carbure de silicium, également noté SiC, puis le nitrure de gallium, également noté GaN, sont actuellement les plus utilisés pour réaliser ces composants de puissance de nouvelle génération, tels que des interrupteurs commandables, en particulier des transistors. Les hautes performances de ces nouveaux composants, à savoir faible résistance à l'état passant, grande vitesse de commutation et forte tenue en température, permettent alors d'améliorer considérablement les performances des convertisseurs, en termes de rendement, d'encombrement et de coût.

Ces composants avec matériaux à large bande nécessitent toutefois une intégration optimisée au sein du système de conversion d'énergie, et une surveillance particulière du fait de leurs caractéristiques spécifiques, ceci pour la sécurité des utilisateurs et la protection des composants électroniques du système de conversion.

Pour la surveillance des convertisseurs d'énergie électrique, on connait alors une détection par mesure de courant, consistant à mesurer le courant dans la branche de commutation à l'aide d'un capteur de courant de type shunt ou Rogowski.

Toutefois, une telle mesure de courant est invasive pour le shunt, et limitée en vitesse de réaction pour les capteurs de courant type Rogowski, et n'est alors pas adapté pour une telle surveillance, notamment lorsque le convertisseur comporte des composants avec matériau à large bande, en particulier pour des composants en nitrure de gallium.

On connaît également une surveillance du convertisseur d'énergie par détection de désaturation du composant, via une mesure aux bornes du composant afin de détecter une telle désaturation.

Cependant, une telle mesure doit pouvoir tenir la haute tension aux bornes du composant, et peut perturber le fonctionnement des composants rapides, avec des capacités parasites additionnelles.

L'article "New Ultra Fast Short Circuit Detection Method Without Using the Desaturation Process of the Power Semiconductor" de S. Hain et al décrit une détection rapide de régime de court-circuit sans utiliser la désaturation des composants de puissance. Une telle détection est effectuée via une inductance parasite connectée en série du composant de puissance surveillé et un circuit de détection associé à cette impédance.

Toutefois, une telle détection est invasive dans la boucle de commande du composant, et implique des inductances parasites de valeurs assez élevées (de l'ordre 10 à 20 nH), voire des surtensions entre les électrodes de drain et de source allant jusqu'à la destruction du composant.

L'article « Short Circuit Detection Methods for Silicon Carbide (SiC) Power Semiconductors » de J. Person et al décrit une détection similaire à celle de l'article précité, via une inductance parasite connectée en série du composant de puissance surveillé ; ainsi qu'une détection via un circuit de détection connecté à un circuit de commande du composant de puissance surveillé.

Cependant, un tel circuit de détection nécessite de tenir des hautes tensions au blocage et implique une détection de faible tension à l'amorçage.

Le but de l'invention est alors de proposer un dispositif et un procédé de surveillance d'un convertisseur d'énergie électrique permettant une surveillance améliorée du convertisseur, notamment lorsque le convertisseur comporte des interrupteurs réalisés en matériau semi-conducteur à large bande.

A cet effet, l'invention a pour objet un dispositif électronique de surveillance d'un convertisseur d'énergie électrique, le convertisseur d'énergie électrique étant apte à convertir une tension d'entrée en une tension de sortie et comprenant une première et une deuxième bornes d'entrée aptes à recevoir la tension d'entrée, au moins deux bornes de sortie aptes à délivrer la tension de sortie, une première branche de filtrage connectée entre les bornes d'entrée, une deuxième branche de filtrage connectée en parallèle de la première branche de filtrage, au moins deux branches de commutation connectées en parallèle de la deuxième branche de filtrage, chaque branche de filtrage comportant un condensateur, chaque branche de commutation comportant deux demi-branches de commutation connectées en série et reliées entre elles en un point intermédiaire, le point intermédiaire de chaque branche de commutation formant alors une borne de sortie respective, chaque demi-branche comportant au moins un interrupteur,
le dispositif de surveillance comprenant une impédance de détection configurée pour être connectée entre les première et deuxième branches de filtrage, et un module de détection configuré pour comparer la tension aux bornes de l'impédance de détection avec un seuil de tension prédéfini, puis pour générer un signal de détection dès que la tension aux bornes de l'impédance de détection est supérieure au seuil de tension prédéfini.

Avec le dispositif de surveillance selon l'invention, la connexion de l'impédance de détection entre les première et deuxième branches de filtrage permet de détecter l'apparition d'un court-circuit dans une branche de commutation respective, tout en perturbant moins le fonctionnement du convertisseur en régime de fonctionnement normal, en comparaison avec les dispositifs de surveillance de l'état de la technique où l'impédance de détection est généralement agencée dans la branche de commutation à surveiller. En comparaison avec les dispositifs de surveillance de l'état de la technique, cela permet également de s'affranchir de courants transitoires lors des commutations des interrupteurs (par exemple, charges et décharge de capacités parasites drain-source des interrupteurs). Ces courants sont rapides et intenses et ressemblent donc à des courts-circuits, mais contrairement à ces derniers ne durent pas longtemps.

Le module de détection permet alors de détecter l'apparition d'un court-circuit dans la branche de commutation en comparant la tension aux bornes de l'impédance de détection avec le seuil de tension prédéfini.

De préférence, la ou chaque impédance de détection est une inductance, et la tension aux bornes de ladite inductance de détection est alors en $L.di/dt$, où $L$ représente la valeur de l'inductance, et $di/dt$ représente la dérivée temporelle du courant, cette dérivée temporelle du courant étant typiquement élevée lors de l'apparition du court-circuit, du fait d'une variation rapide du courant, notamment lorsque les interrupteurs de la branche de commutation sont réalisés en un matériau semi-conducteur à large bande. La tension aux bornes de l'inductance de détection est alors suffisamment élevée pour permettre une détection facilitée et efficace de l'apparition du court-circuit.

Suivant d'autres aspects avantageux de l'invention, le dispositif électronique de surveillance comprend une ou plusieurs des caractéristiques suivantes, prises isolément ou suivant toutes les combinaisons techniquement possibles :

- chaque branche de filtrage comporte une première extrémité reliée à la première borne d'entrée et une deuxième extrémité reliée à la deuxième borne d'entrée ; et l'impédance de détection comporte au moins une impédance parmi une première impédance configurée pour être connectée entre lesdites premières extrémités et une deuxième impédance configurée pour être connectée entre lesdites deuxièmes extrémités ;
- la ou chaque impédance est une inductance ;

l'inductance étant de préférence une inductance parasite associée à une liaison de connexion entre les première et deuxième branches de filtrage ;

- l'impédance de détection présente une valeur d'inductance comprise entre 10 nH et 100 nH ;
- la ou chaque impédance est une résistance ;
- le module de détection comporte un étage redresseur, un étage de protection contre une surtension, un étage de détection de franchissement du seuil de tension prédéfini, et un étage de protection contre une surintensité ;

les étages redresseur, de protection contre une surtension, de détection de franchissement et protection contre une surintensité étant de préférence connectés successivement l'un après l'autre ;
l'étage de détection de franchissement étant de préférence formé d'une diode Zener de tension d'amorçage égale au seuil de tension prédéfini ;

- le module de détection comporte un optocoupleur configuré pour générer le signal de détection, l'optocoupleur étant relié à l'étage de détection de franchissement ;

l'étage de protection contre une surintensité étant de préférence connecté entre l'étage de détection de franchissement et l'optocoupleur ;

L'invention a aussi pour objet un système de conversion d'énergie électrique, comprenant un convertisseur d'énergie électrique apte à convertir une tension d'entrée en une tension de sortie et un dispositif de surveillance du convertisseur d'énergie électrique,

le convertisseur comprenant une première et une deuxième bornes d'entrée aptes à recevoir la tension d'entrée, au moins deux bornes de sortie aptes à délivrer la tension de sortie, une première branche de filtrage connectée entre les bornes d'entrée, une deuxième branche de filtrage connectée en parallèle de la première branche de filtrage, au moins deux branches de commutation connectées en parallèle de la deuxième branche de filtrage, chaque branche de filtrage comportant un condensateur, chaque branche de commutation comportant deux interrupteurs reliés en un point milieu, le point milieu de chaque branche de commutation formant alors une borne de sortie respective, chaque demi-branche comportant au moins un interrupteur,
le dispositif de surveillance étant tel que défini ci-dessus, et l'impédance de détection est connectée entre les première et deuxième branches de filtrage.

Suivant d'autres aspects avantageux de l'invention, le système de conversion d'énergie électrique comprend une ou plusieurs des caractéristiques suivantes, prises isolément ou suivant toutes les combinaisons techniquement possibles :

- chaque interrupteur comporte un composant semi-conducteur de commutation, tel qu'un transistor ;
- chaque composant semi-conducteur de commutation est réalisé en un matériau choisi parmi le groupe consistant en : nitrure de gallium, carbure de silicium et silicium ; et
- chaque composant semi-conducteur de commutation est réalisé en un matériau semi-conducteur à large bande, tel que le nitrure de gallium ou le carbure de silicium.

L'invention a également pour objet un procédé de surveillance d'un convertisseur d'énergie électrique, le convertisseur d'énergie électrique étant apte à convertir une tension d'entrée en une tension de sortie et comprenant une première et une deuxième bornes d'entrée aptes à recevoir la tension d'entrée, au moins deux bornes de sortie aptes à délivrer la tension de sortie, une première branche de filtrage connectée entre les bornes d'entrée, une deuxième branche de filtrage connectée en parallèle de la première branche de filtrage, au moins deux branches de commutation connectées en parallèle de la deuxième branche de filtrage, chaque branche de filtrage comportant un condensateur, chaque branche de commutation comportant deux demi-branches de commutation connectées en série et reliées entre elles en un point intermédiaire, le point intermédiaire de chaque branche de commutation formant alors une borne de sortie respective, chaque demi-branche comportant au moins un interrupteur,
le procédé comprenant les étapes suivantes :

- connexion d'une impédance de détection entre les première et deuxième branches de filtrage ;
- comparaison de la tension aux bornes de l'impédance de détection avec un seuil de tension prédéfini ; et
- génération d'un signal de détection dès que la tension aux bornes de l'impédance de détection est supérieure au seuil de tension prédéfini.

L'invention a aussi pour objet l'utilisation d'un dispositif électronique de surveillance pour surveiller un convertisseur d'énergie électrique, le convertisseur d'énergie électrique étant apte à convertir une tension d'entrée en une tension de sortie et comprenant une première et une deuxième bornes d'entrée aptes à recevoir la tension d'entrée, au moins deux bornes de sortie aptes à délivrer la tension de sortie, une première branche de filtrage connectée entre les bornes d'entrée, une deuxième branche de filtrage connectée en parallèle de la première branche de filtrage, au moins deux branches de commutation connectées en parallèle de la deuxième branche de filtrage, chaque branche de filtrage comportant un condensateur, chaque branche de commutation comportant deux demi-branches de commutation connectées en série et reliées entre elles en un point intermédiaire, le point intermédiaire de chaque branche de commutation formant alors une borne de sortie respective, chaque demi-branche comportant au moins un interrupteur, et
lors de son utilisation, le dispositif de surveillance comprend une impédance de détection connectée entre les première et deuxième branches de filtrage, et un module de détection configuré pour comparer la tension aux bornes de l'impédance de détection avec un seuil de tension prédéfini, puis pour générer un signal de détection dès que la tension aux bornes de l'impédance de détection est supérieure au seuil de tension prédéfini.
Ces caractéristiques et avantages de l'invention apparaîtront plus clairement à la lecture de la description qui va suivre, donnée uniquement à titre d'exemple non limitatif, et faite en référence aux dessins annexés, sur lesquels :

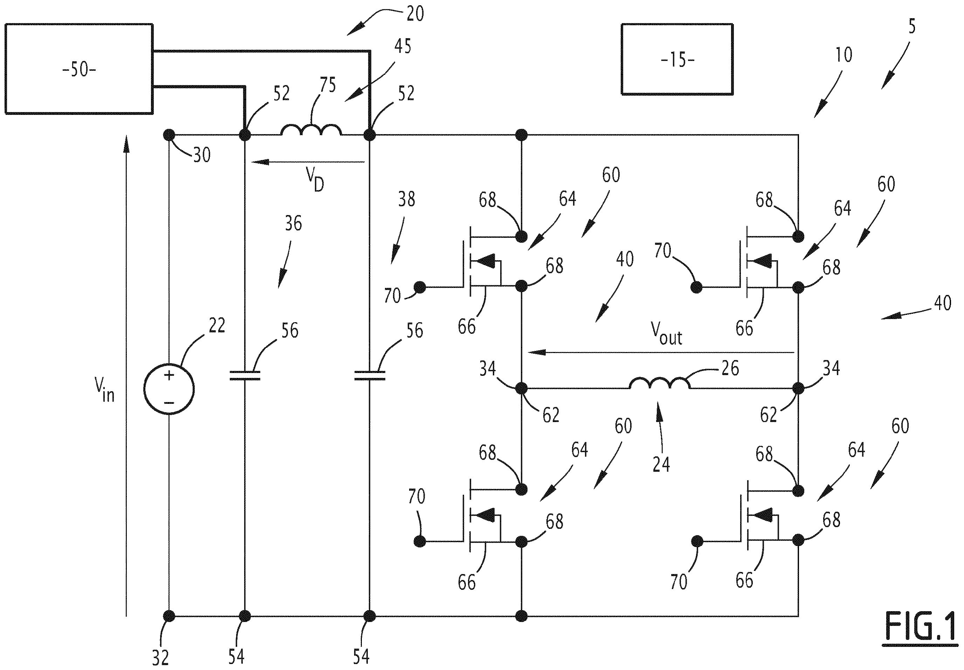

- la figure 1 est une représentation schématique d'un système de conversion d'énergie électrique selon l'invention, le système de conversion comprenant un convertisseur d'énergie électrique, un dispositif de commande du convertisseur d'énergie électrique et un dispositif de surveillance dudit convertisseur d'énergie électrique, le dispositif de surveillance comportant une impédance de détection et un module de détection apte à comparer la tension aux bornes de l'impédance de détection avec un seuil de tension prédéfini, puis à générer un signal de détection en cas de franchissement dudit seuil ;

- la figure 2 est une représentation schématique du module de détection de la figure 1 ;
- la figure 3 est un organigramme d'un procédé de surveillance selon l'invention du convertisseur d'énergie électrique de la figure 1 ;
- la figure 4 est une vue analogue à celle de la figure 1, illustrant en outre l'apparition d'un court-circuit dans une branche de commutation du convertisseur d'énergie électrique ;
- la figure 5 est une courbe représentant l'évolution en fonction du temps de la tension aux bornes de l'impédance de détection de la figure 1 ; et
- la figure 6 est un ensemble de courbes illustrant la durée nécessaire à la détection de l'apparition d'un court-circuit par le module de détection de la figure 1.

Sur la figure 1, un système de conversion d'énergie électrique 5 comprend un convertisseur d'énergie électrique 10 apte à convertir une tension d'entrée $V_{in}$ en une tension de sortie $V_{out}$, un dispositif 15 de commande du convertisseur d'énergie électrique 10, et un dispositif 20 de surveillance dudit convertisseur d'énergie électrique 10.

Le système de conversion d'énergie électrique 5 est alors configuré pour convertir une énergie d'entrée, typiquement fournie par une source 22, en une énergie de sortie, typiquement consommée par une charge 24, telle qu'une bobine électromagnétique 26 d'un moteur électrique, non représenté.

En complément, le système de conversion 5 est un système de conversion réversible, et est alors configuré pour convertir l'énergie électrique de la sortie en l'énergie électrique de l'entrée.

Dans l'exemple de la figure 1, le système de conversion 5 est un système de conversion continu-alternatif, également appelé système de conversion DC-AC, configuré alors pour convertir une énergie électrique continue en une énergie électrique alternative.

En variante, le système de conversion 5 est un système de conversion continu-continu, également appelé système de conversion DC-DC (de l'anglais *Direct Current - Direct Current*), et est alors configuré pour convertir une énergie électrique continue en une autre énergie électrique continue.

Lorsque le système de conversion 5 est un système de conversion continu-alternatif, le convertisseur 10 est également un convertisseur continu-alternatif, et la tension d'entrée $V_{in}$ est alors une tension continue, la tension de sortie $V_{out}$ étant une tension alternative. Dans ce cas, le convertisseur 10 forme alors un onduleur de tension.

Lorsqu'en variante le système de conversion 5 est un système de conversion continu-continu, alors le convertisseur 10 est également un convertisseur continu-continu, et les tensions d'entrée $V_{in}$ et de sortie $V_{out}$ sont alors chacune une tension continue. Selon cette variante, le convertisseur 10 forme alors un hacheur de tension.

Le convertisseur 10 comprend deux bornes d'entrées 30, 32, à savoir une première borne d'entrée 30 et une deuxième borne d'entrée 32, aptes à recevoir la tension d'entrée $V_{in}$, au moins deux bornes de sortie 34 aptes à délivrer la tension de sortie $V_{out}$, une première branche de filtrage 36 connectée entre les bornes d'entrées 30, 32, une deuxième branche de filtrage 38 connectée en parallèle de la première branche de filtrage 36, et au moins deux branches de commutation 40 connectées en parallèle de la deuxième branche de filtrage 38.

Comme connu en soi, lorsque le convertisseur 10 est un convertisseur continu-alternatif, il comporte une branche de commutation 40 pour chaque phase de la tension de sortie $V_{out}$. L'homme du métier observera alors par exemple que si la tension de sortie $V_{out}$ est une tension monophasée, alors le convertisseur 10 comporte deux branches de commutation 40, et que si la tension de sortie $V_{out}$ est une tension triphasée, alors il comporte trois branches de commutation 40, avec une connexion, typiquement en étoile ou en triangle, des charges 24 entre les points milieux des branches de commutation 40.

Dans l'exemple de la figure 1, par souci de simplification du dessin, seules deux branches de commutation 40 sont représentées, et l'homme du métier comprendra que cet exemple correspond au cas d'une tension de sortie $V_{out}$ alternative, quel que soit le nombre de phases de cette tension de sortie $V_{out}$.

Le dispositif de commande 15 est configuré pour commander le convertisseur 10. Plus précisément, le dispositif de commande 15 est configuré pour commander les branches de commutation 40, afin de convertir la tension d'entrée $V_{in}$ en l'attention de sortie $V_{out}$.

Le dispositif de surveillance 20 est configuré pour surveiller le convertisseur 10, et en particulier pour détecter l'apparition d'un éventuel court-circuit dans une branche de commutation 40 respective.

Selon l'invention, le dispositif de surveillance 20 comprend une impédance de détection 45 configurée pour être connectée entre les première 36 et deuxième 38 branches de filtrage, et un module de détection 50 configuré pour comparer la tension $V_D$ aux bornes de l'impédance de détection 45 avec un seuil de tension prédéfini S, puis pour générer un signal de détection dès que la tension $V_D$ aux bornes de l'impédance de détection 45 est supérieure au seuil de tension prédéfini S. Dans l'exemple de la figure 1, l'impédance de détection 45 est connectée entre la première branche de filtrage 36 et la deuxième branche de filtrage 38 au sein du système de conversion 5.

Chaque branche de filtrage 36, 38 comporte une première extrémité 52 reliée à la première borne d'entrée 30, une deuxième extrémité 54 reliée à la deuxième borne d'entrée 32, et un condensateur 56 connecté entre les première et deuxième extrémités 52, 54.

Chaque branche de commutation 40 comporte deux demi-branches de commutation 60 connectées en série et reliées entre elles en un point intermédiaire 62, le point intermédiaire 62 de chaque branche de commutation 40 formant alors une borne de sortie 34 respective. Chaque demi-branche de commutation 60 comporte au moins un interrupteur 64, chaque interrupteur 64 étant commandable par le dispositif de commande 15. Dans l'exemple de la figure 1, chaque demi-branche de commutation 60 comporte un seul interrupteur 64. En variante non représentée, chaque demi-branche de commutation 60 comporte plusieurs interrupteurs 64 connectés en série. Ceci permet alors de convertir une énergie électrique de tension plus élevée.

Au moins un interrupteur 64 est par exemple, un interrupteur bidirectionnel en courant. Chaque interrupteur 64 est de préférence un interrupteur bidirectionnel en courant. En outre, si le convertisseur 10 et en particulier les interrupteurs 64 doivent tenir à la fois une tension positive et une tension négative, alors au moins un, et de préférence chaque, interrupteur 64 est un interrupteur bidirectionnel à la fois en courant et en tension.

Lorsque tous les interrupteurs 64 sont bidirectionnels en courant, le convertisseur d'énergie électrique 10 est alors un convertisseur bidirectionnel configuré pour convertir l'énergie électrique d'entrée en l'énergie électrique de sortie si le courant circule depuis les bornes d'entrées 30, 32 vers les bornes de sorties 34, et inversement configuré pour convertir l'énergie de sortie en l'énergie d'entrée si le courant circule depuis les bornes de sorties 34 vers les bornes d'entrées 30, 32.

Ce fonctionnement du convertisseur d'énergie électrique 10 en inverse pour convertir l'énergie électrique de sortie en l'énergie électrique d'entrée est notamment utile pour récupérer de l'énergie, typiquement lorsque le système de conversion 5 est embarqué à bord d'un véhicule électrique de transport, l'énergie étant alors récupérée lors d'un freinage dudit véhicule.

Chaque interrupteur 64 comporte typiquement un composant semi-conducteur commandable de commutation 66, tel qu'un transistor. Comme connu en soi, chaque composant semi-conducteur commandable de commutation 66 comporte deux électrodes de conduction 68 et une électrode de commande 70, chaque composant semi-conducteur de commutation 66 étant alors commandable, via son électrode de commande 70, entre un état parmi un état passant dans lequel le courant circule entre les électrodes de conduction 68, et un état bloqué dans lequel le courant ne circule pas entre les électrodes de conduction 68.

Lorsqu'on complément l'interrupteur 64 est un interrupteur bidirectionnel en courant, il comporte par exemple en outre une diode, non représentée, connectée en antiparallèle du composant semi-conducteur de commutation 66. La diode est alors connectée entre les électrodes de conduction 68. L'homme du métier observera que lorsque l'interrupteur 64 est réalisé en nitrure de gallium, une telle diode n'est pas nécessaire, un interrupteur en nitrure de gallium étant réversible en courant naturellement.

Chaque composant semi-conducteur commandable de commutation 66, tel qu'un transistor respectif, est typiquement réalisé en nitrure de gallium, également noté GaN, en carbure de silicium, également noté SiC, ou encore en silicium également noté Si. Chaque composant semi-conducteur de commutation 66 est de préférence réalisé en nitrure de gallium ou en carbure de silicium.

Lorsque le composant semi-conducteur de commutation 66 est un transistor, tel qu'un transistor à effet de champ à grille isolée, également appelé MOSFET (de l'anglais *Metal Oxide Semiconductor Field Effect Transistor*), les électrodes de conduction 68 sont également appelées respectivement électrode de drain et électrode de source, et l'électrode de commande 70 est également appelée électrode de grille.

L'impédance de détection 45 comporte au moins une impédance parmi une première impédance 75 configurée pour être connectée entre les premières extrémités 52 et une deuxième impédance, non représentée, configurée pour être connectée entre les deuxièmes extrémités 54.

Dans l'exemple de la figure 1, le dispositif de surveillance 20 comporte une seule impédance connectée entre des extrémités 52, 54 respectives, à savoir la première impédance 75 connectée entre les premières extrémités 52.

En variante, la seule impédance du dispositif de surveillance 20 est la deuxième impédance connectée entre les deuxièmes extrémités 54.

En variante encore, le dispositif de surveillance 20 comporte deux impédances de détection 45, à savoir la première impédance 75 connectée entre les premières extrémités 52 et la deuxième impédance connectée entre les deuxièmes extrémités 54.

Selon cette variante où l'impédance de détection 45 comporte deux impédances, à savoir la première impédance 75 et la deuxième impédance, l'homme du métier comprendra alors que la tension $V_D$ aux bornes de l'impédance de détection 45 est la somme des tensions aux bornes de chacune des première et deuxième impédances, et le module de détection 50 est alors connecté aux bornes de chacune des première et deuxième impédances.

La ou chaque impédance est par exemple une inductance, et de préférence une inductance parasite associée à une liaison de connexion entre les première 36 et deuxième 38 branches de filtrage. Autrement dit, lorsque l'inductance est une inductance parasite, l'inductance est alors l'inductance parasite de la liaison de connexion respective entre les première 36 et deuxième 38 branches de filtrage.

Dans l'exemple de la figure 1, la première impédance 75 est une telle inductance parasite, et correspond alors à l'inductance parasite de la liaison de connexion entre les premières extrémités 52 des première 36 et deuxième 38 branches de filtrage.

Lorsque la ou chaque impédance est une inductance, la valeur d'inductance est par exemple comprise entre 10nH et 100nH.

En variante, la ou chaque impédance est une résistance.

Le module de détection 50 est connecté aux bornes de l'impédance de détection 45, et configuré pour détecter l'apparition potentielle d'un court-circuit dans l'une des branches de commutation 40 en comparant la tension $V_D$ aux bornes de l'impédance de détection 45 avec le seuil de tension prédéfini S, puis en générant un signal de détection correspondant à l'apparition d'un tel court-circuit, dès que la tension $V_D$ aux bornes de l'impédance de détection 45 est supérieure au seuil de tension prédéfini S.

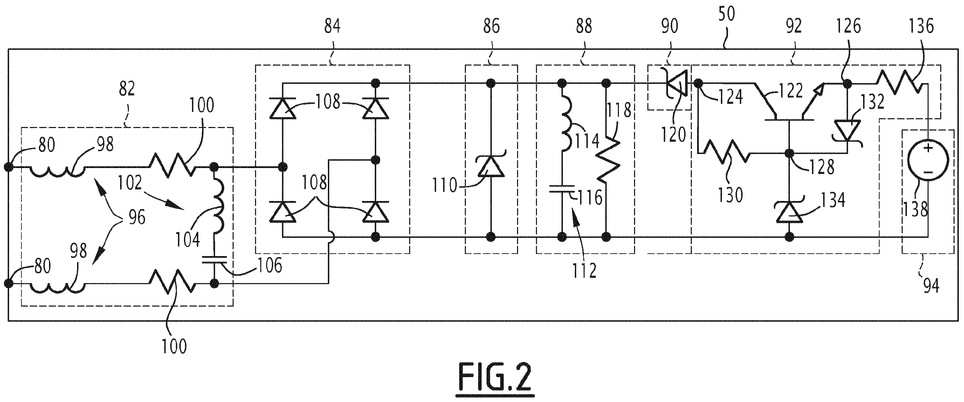

Dans l'exemple de la figure 2, le module de détection 50 comporte deux bornes de connexion 80 aptes à être connectées aux bornes de l'impédance de détection 45, un étage de filtrage 82, un étage redresseur 84, un étage 86 de protection contre une surtension, un étage 88 de détection d'enveloppe, un étage 90 de détection de franchissement du seuil de tension prédéfini S, un étage 92 de protection contre une surintensité, et un étage 94 de génération du signal de détection.

Les étages de filtrage 82, redresseur 84, de protection contre une surtension 86, de détection d'enveloppe 88, de détection de franchissement 90, de protection contre une surintensité 92 et de génération du signal de détection 94 sont de préférence connectés successivement l'un après l'autre. Dans l'exemple de la figure 2, l'étage de filtrage 82 est alors connecté aux bornes de connexion 80, l'étage redresseur 84 est connecté en sortie de l'étage de filtrage 82, l'étage de protection contre une surtension 86 est connecté en sortie de l'étage redresseur 84, l'étage de détection d'enveloppe 88 est connecté en sortie de l'étage de protection contre une surtension 86, l'étage de détection de franchissement 90 est connecté en sortie de l'étage de détection d'enveloppe 88, l'étage de protection contre une surintensité 92 est connecté en sortie de l'étage de détection de franchissement 90, et l'étage de génération 94 est connecté en sortie de l'étage de protection contre un surintensité 92.

L'homme du métier observera que, pour comparer la tension $V_D$ aux bornes de l'impédance de détection 45 avec le seuil de tension prédéfini S, puis pour générer le signal de détection, seuls les étages de détection de franchissement 90 et de génération du signal de détection 94 sont nécessaires, et que les autres étages du module de détection 50, à savoir l'étage de filtrage 82, l'étage redresseur 84, les étages de protection 86, 92 et l'étage de détection d'enveloppe 88 sont optionnels. En effet, l'étage de filtrage 82 sert à effectuer un filtrage du premier ordre optionnel, l'étage redresseur 84 sert à convertir la tension $V_D$ aux bornes de l'impédance de détection 45 en une tension continue lorsque la tension $V_D$ est alternative, l'étage de détection d'enveloppe 88 sert à mémoriser une valeur maximale de l'amplitude de la tension redressée, c'est-à-dire de la tension continue, afin d'améliorer la détection, l'étage de protection contre les surtensions 86 sert à protéger les étages en avals (i.e. les étages de détection d'enveloppe 88, de détection de franchissement 90, de protection contre une surintensité 92 et de génération 94) contre une éventuelle surtension aux bornes de l'impédance de détection 45, et l'étage de protection contre une surintensité 92 sert à protéger l'étage de génération 94 contre une telle surintensité.

Dans l'exemple de la figure 2, l'étage de filtrage 82 comporte deux bras de filtrage 96, chacun étant connecté à une borne de connexion 80 respective et comportant une bobine électromagnétique 98 et une résistance 100 connectées en série, ainsi qu'un bras LC 102 connecté entre les bras de filtrage 96 et comportant une bobine électromagnétique 104 et un condensateur 106 connectés en série, le bras LC 102 étant typiquement connecté aux résistances 100 de chacun des bras de filtrage 96.

L'étage redresseur 84 est formé d'un pont de diodes 108, comme connu en soi.

L'étage de protection contre une surtension 86 comporte une diode Zener 110 connectée en sortie de l'étage redresseur 84, la diode Zener 110 étant de préférence connectée entre des bornes de sortie de l'étage redresseur 84, aptes à délivrer la tension continue issue dudit étage redresseur 84.

L'étage de détection d'enveloppe 88 comporte un bras LC 112 connecté entre les bornes de sortie de l'étage redresseur 84 formant des bornes d'application de la tension continue, le bras LC étant formé d'une bobine électromagnétique 114 et d'un condensateur 116 connectés en série. En complément, l'étage de détection d'enveloppe 88 comporte une résistance 118 connectée en parallèle du bras LC 112.

L'étage de détection de franchissement 90 est connecté au potentiel positif de la tension continue, c'est-à-dire à la borne positive d'application de la tension continue, et est par exemple formé d'une diode Zener 120 dont la tension d'amorçage est égale au seuil de tension prédéfini S. La diode Zener 120 est reliée par sa cathode à la borne positive de sortie de l'étage redresseur 84, et par son anode à l'étage de protection contre une surintensité 92, connecté en sortie de l'étage de détection de franchissement 90.

L'étage de protection contre une surintensité 92 comporte un transistor 122, tel qu'un transistor bipolaire, comportant une première électrode de conduction 124 connectée à l'étage de détection de franchissement 90, et en particulier à l'anode de la diode Zener 120, une deuxième électrode de conduction 126 et une électrode de commande 128. L'étage de protection contre une surintensité 92 comporte en outre une résistance 130 connectée entre la première électrode de conduction 124 et l'électrode de commande 128, une diode Zener 132 connectée entre la deuxième électrode de conduction 126 et l'électrode de commande 128, la diode Zener 132 étant de préférence connectée par sa cathode à l'électrode de commande 128 et par son anode à la deuxième électrode de conduction 126. L'étage de protection contre une surintensité 92 comprend également une autre diode Zener 134 connectée par sa cathode à l'électrode de commande 128 et par son anode au potentiel négatif de la tension continue, ainsi qu'une résistance 136 connectée par une extrémité à la deuxième électrode de conduction 126, et dont l'autre extrémité est connectée à l'étage de génération 94.

L'étage de génération 94 comporte par exemple un optocoupleur 138 apte à générer le signal de détection sous forme d'un signal optique, l'optocoupleur 138 étant relié à l'étage de détection 90 via l'étage de protection contre une surintensité 92. Dans l'exemple de la figure 2, l'optocoupleur 138 est connecté entre la résistance 136 et l'anode de l'autre diode Zener 134 de l'étage de protection contre une surintensité 92.

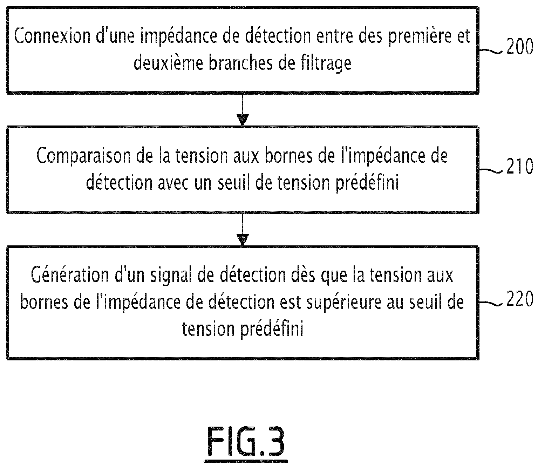

Le fonctionnement du système de conversion d'énergie électrique 5, et en particulier du dispositif de surveillance 20 selon l'invention, va être à présent expliqué en regard de la figure 3 représentant un organigramme du procédé de surveillance du convertisseur d'énergie électrique 10 selon l'invention.

Lors d'une étape initiale 200, l'impédance de détection 45 est connectée entre les première 36 et deuxième 38 branches de filtrage, et le module de détection 50 est ensuite connecté aux bornes de l'impédance de détection 45.

L'homme du métier comprendra que lorsque l'impédance de détection 45 est en forme d'une impédance parasite, telle qu'une inductance parasite, associée à la liaison de connexion entre les première 36 et deuxième 38 branches de filtrage, alors l'impédance de détection 45 ne nécessite - à proprement parler - pas d'être connectée entre les première 36 et deuxième 38 branches de filtrage, l'impédance de détection 45 étant alors inhérente à la liaison de connexion déjà présente entre les première 36 et deuxième 38 branches de filtrage. La liaison de connexion entre les première 36 et deuxième 38 branches de filtrage nécessite néanmoins dans ce cas d'être dimensionnée afin de présenter l'impédance parasite souhaitée, telle qu'une impédance parasite de valeur comprise entre 10 nH et 100 nH.

Lors d'une étape suivante 210, le dispositif de surveillance 20 compare alors la tension $V_D$ aux bornes de l'impédance de détection 45 avec le seuil de tension prédéfini S. Cette comparaison de la tension $V_D$ avec le seuil de tension prédéfini S est effectuée en particulier par le module de détection 50, et typiquement via l'étage de détection de franchissement 90.

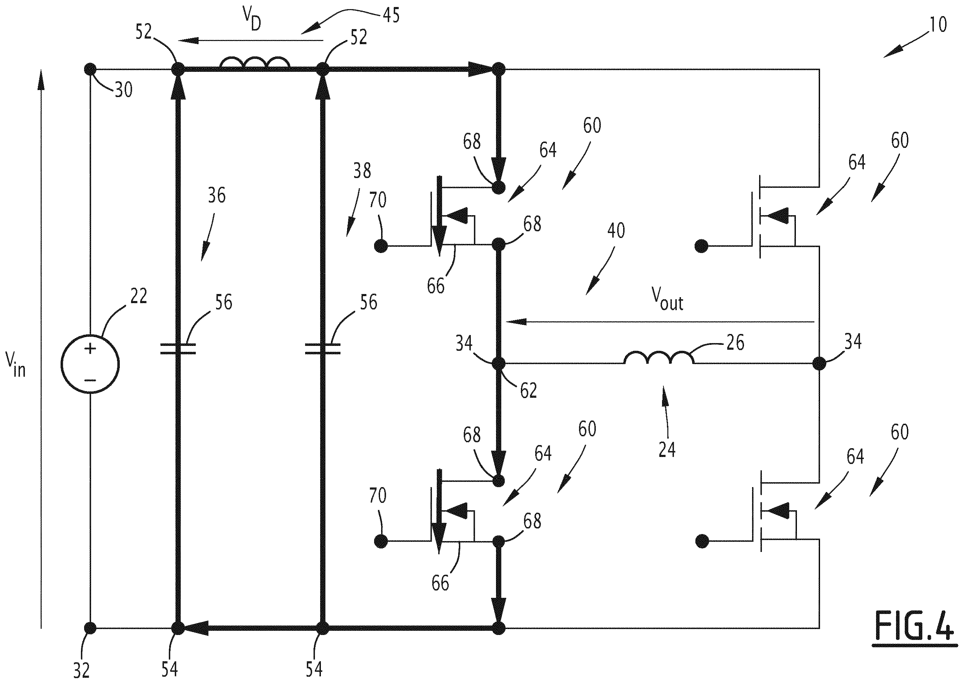

Lors de l'apparition d'un court-circuit dans l'une des branches de commutation 40, c'est-à-dire lorsque les deux demi-branches de commutation 60 d'une même branche de commutation 40 sont passantes en même temps, comme représenté sur la figure 4 où les flèches en gras symbolisent la circulation du courant, la tension $V_D$ aux bornes de l'impédance de détection 45 augmente brutalement. En fonctionnement normal du convertisseur 10, une seule des deux demi-branches 60 d'une même branche de commutation 40 est passante à la fois ; c'est-à-dire pour chaque branche de commutation 40, une seule demi-branche 60 est passante à chaque instant temporel.

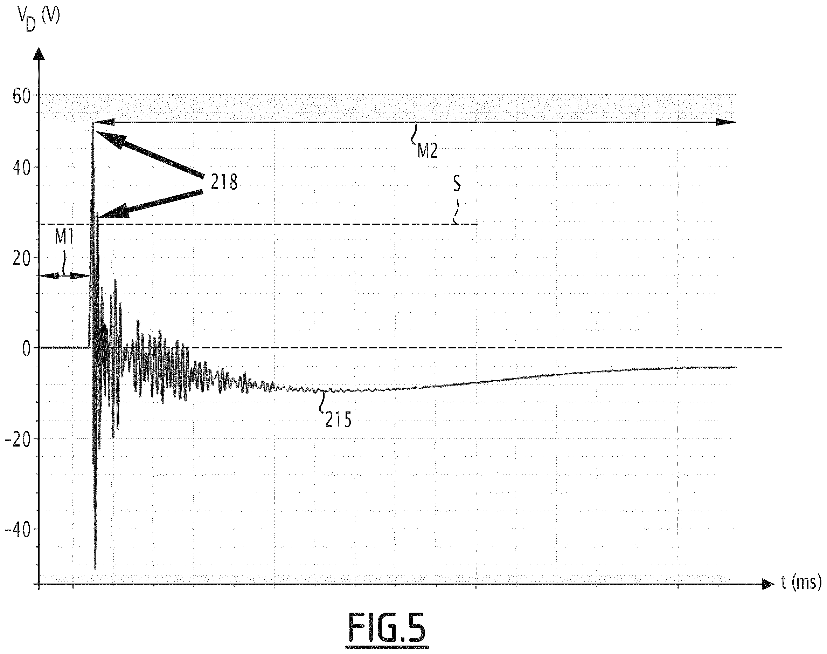

Cette brusque évolution de la tension $V_D$ aux bornes de l'impédance de détection 45 est visible sur la figure 5 où une courbe 215 représente l'évolution temporelle de ladite tension $V_D$. Cette courbe 215 montre alors plusieurs pics de tension 218 correspondant à l'apparition du court-circuit dans le convertisseur 10, et en particulier dans au moins l'une des branches de commutation 40. Ces pics de tension 218 marquent le début du fonctionnement en régime de court-circuit du convertisseur 10, représenté par la flèche M2, faisant suite à un fonctionnement normal du convertisseur 10 représenté par la flèche M1. L'homme du métier observera alors que lors du fonctionnement normal du convertisseur 10 (flèche M1), la tension $V_D$ aux bornes de l'impédance de détection 45 est faible, et proche de la tension nulle dans l'exemple de la figure 5, puis augmente brutalement lors de l'apparition du court-circuit (début de la flèche M2) et atteint alors les pics de tension 218.

Ces pics de tension 218 dépassent le seuil de détection prédéfini S, et la tension $V_D$ aux bornes de l'impédance de détection 45 est alors supérieure audit seuil de tension prédéfini S, par exemple égale à 27 volts dans l'exemple de la figure 5.

Dès que la tension $V_D$ aux bornes de l'impédance de détection 45 est supérieure au seuil de tension prédéfini S, le procédé de surveillance passe alors à l'étape suivante 220 lors de laquelle le dispositif de surveillance 20 génère le signal de détection afin d'indiquer que la tension $V_D$ aux bornes de l'impédance de détection 45 est supérieure au seuil de tension prédéfini S, et qu'un court-circuit est alors probablement apparu dans le convertisseur 10. Cette génération du signal de détection est effectuée par le module de détection 50, et en particulier par l'étage de génération 94, tel que l'optocoupleur 138.

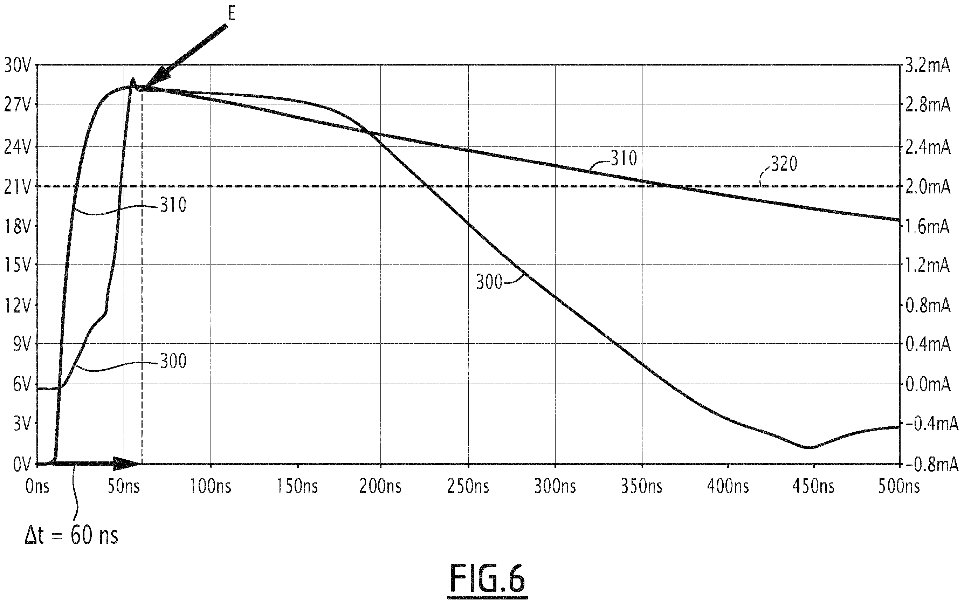

La détection de la part du module de détection 50 est alors particulièrement efficace et réactive, puisque le module de détection 50 génère le signal de détection en un laps de temps $\Delta t$ de l'ordre de 60 ns, comme représenté sur la figure 6 où l'instant de déclenchement de l'optocoupleur 138 représenté par la flèche E se déroule environ 60 ns après l'apparition du court-circuit.

Dans l'exemple de la figure 6, la courbe 300 représente le courant traversant l'optocoupleur 138, la courbe 310 représente une tension générée simulant un court-circuit afin de valider le module de détection 50, et la courbe 320 représente un seuil de déclenchement de l'optocoupleur 138, sensiblement égal à 2 mA.

L'homme du métier observera alors que sur la figure 6, l'instant de déclenchement de l'optocoupleur 138, représenté par le trait vertical en pointillé et la flèche E, est légèrement décalé temporellement par rapport à l'intersection de la courbe 300 (représentant le courant à travers l'optocoupleur 138) avec la coupe 320 (représentant le seuil de déclenchement de cet optocoupleur), et ce léger décalage temporel (de l'ordre de 10 ns) est dû à un temps de propagation à l'intérieur de l'optocoupleur 138 lui-même.

L'homme du métier observera également que la durée pendant laquelle la tension de court-circuit est supérieure au seuil de tension S, sensiblement égal à 27 volts dans l'exemple des figures 5 et 6, est relativement réduite, de l'ordre de 100 ns (entre les instants temporels 30 ns et 130 ns), ce qui permet d'éviter des déclenchements intempestifs de détection de court-circuit, c'est-à-dire des fausses alarmes.

En outre, après détection du court-circuit, l'optocoupleur 138 a suffisamment de temps pour générer le signal de détection, puisque cette génération est possible à partir du déclenchement de l'optocoupleur 138 représenté par la flèche E et tant que le courant traversant l'optocoupleur 138 est supérieur au seuil de déclenchement, c'est-à-dire pendant plus de 150 ns (entre les instants temporels 60 ns et 225 ns).

La valeur de l'impédance de détection 45 dépend typiquement du matériau dans lequel sont réalisés les composants semi-conducteurs de commutation 66. À titre d'exemple, lorsque l'impédance de détection 45 est une inductance, la valeur de l'inductance est de l'ordre de quelques dizaines de nH si le matériau du composant semi-conducteur de commutation 66 est le nitrure de gallium (GaN), et de l'ordre d'une centaine de nH si le matériau du composant semi-conducteur de commutation 66 est du carbure de silicium (SiC) ou du silicium (Si). En effet, le temps de commutation du composant semi-conducteur de commutation 66 est bien plus bref lorsque ledit composant de commutation 66 est réalisé en nitrure de gallium, le temps de commutation étant alors typiquement de l'ordre de 10 ns, que lorsque ledit composant de commutation 66 est réalisé en carbure de silicium ou en silicium, le temps de commutation étant alors de l'ordre de 50 à 100 ns, ce qui implique une inductance de détection 5 à 10 fois plus élevée. En effet, lorsque l'impédance de détection 45 est une inductance, la tension $V_D$ aux bornes de ladite inductance est en L.di/dt où L est la valeur de l'inductance de détection, et di/dt représente la dérivée temporelle du courant, c'est-à-dire sa variation temporelle. En cas d'apparition d'un court-circuit, le delta de temps dt correspond donc sensiblement au temps de commutation du composant semi-conducteur de commutation 66, et l'homme du métier observera alors que plus ledit composant de commutation 66 commute rapidement, plus la tension $V_D$ aux bornes de l'impédance de détection 45 sera élevée pour une même valeur d'impédance. Il est donc préférable de faire varier la valeur de l'impédance en fonction du matériau du composant de commutation 66, afin d'avoir à peu près la même tension aux bornes de l'impédance de détection 45 d'une technologie de composant de commutation 66 à l'autre, et en particulier d'avoir sensiblement le même seuil de détection prédéfini S quel que soit le matériau du composant semi-conducteur de commutation 66.

Ainsi, le dispositif de surveillance 20 et le procédé de surveillance selon l'invention permettent de détecter rapidement l'apparition d'un court-circuit dans l'une des branches de commutation 40 du convertisseur 10, puisque la mise en sécurité du convertisseur 10 requiert de 100 à 200 ns environ à partir de l'apparition du court-circuit, la durée entre les 60 ns requises pour la détection du court-circuit par le module de détection 50 et la mise en sécurité correspondant à la durée de génération du signal par l'étage de génération 94, telle que la durée de génération du signal optique par l'optocoupleur 138, suivie de la durée de traitement de l'information par un microcontrôleur recevant ledit signal optique, et enfin de la durée de commande des interrupteurs 64 du convertisseur 10 en position ouverte pour la mise en sécurité dudit convertisseur.

L'homme du métier observera que cette rapidité de mise en sécurité est d'autant plus importante si les interrupteurs 64 comportent des composants semi-conducteur de commutation 66 réalisés en nitrure de galium puisque la durée de tenue au court-circuit du composant semi-conducteur de commutation 66 est de l'ordre de 1 µs lorsque le composant de commutation 66 est réalisé en nitrure de gallium, et de l'ordre de 10 µs lorsque celui-ci est réalisé en silicium, et de l'ordre de 100 à 200 µs lorsque celui-ci est réalisé en carbure de silicium. Cette différence de tenue en court-circuit selon le matériau du composant semi-conducteur de commutation 66 est liée à la tenue en énergie, en régime adiabatique, de tels composants. En effet, la tenue en énergie est de l'ordre de 10 à 20 $J/cm^2$ pour le carbure de silicium de l'ordre de 1 $J/cm^2$ pour le silicium, et de l'ordre de 0,1 $J/cm^2$ pour le nitrure de gallium.

En complément, la capacité du condensateur 56, en particulier celui de la deuxième branche de filtrage 38 au plus près des branches de commutation 40, est dimensionnée pour que les interrupteurs 64 en court-circuit tiennent l'énergie de décharge de la branche de filtrage 36, 38 correspondante, en particulier de la deuxième branche de filtrage 38.

Selon ce complément, la capacité du condensateur 56 doit par exemple vérifier l'équation suivante :

[1]

$$C < \frac{2.E_R}{V^2}$$

où C représente la capacité du condensateur 56,

$E_R$ représente la tenue en énergie de l'interrupteur 64 ; et

V représente la tension aux bornes de la branche de filtrage 36, 38 correspondante.

A titre d'exemple, pour une tenue en énergie $E_R$ de 0,1 J si le composant semi-conducteur de commutation 66 est en nitrure de gallium avec une surface de 1 cm$^2$, et une tension de branche de filtrage de 400 V, la capacité C du condensateur 56 doit être inférieure, de préférence très inférieure, à 1,25 µF.

Le dispositif de surveillance 20 et le procédé de surveillance selon l'invention permettent alors d'effectuer une détection très rapide de l'apparition d'un court-circuit dans le convertisseur 10, tout en ne perturbant pas le fonctionnement du convertisseur 10 en régime nominal, lorsque celui-ci fonctionne normalement.

On conçoit ainsi que le dispositif de surveillance 20 et le procédé de surveillance selon l'invention permettent une surveillance améliorée du convertisseur 10, notamment lorsque le convertisseur 10 comporte des interrupteurs 64 réalisés en matériau semi-conducteur à large bande.

## Revendications

1. Dispositif électronique (20) de surveillance d'un convertisseur d'énergie électrique (10), le convertisseur d'énergie électrique (10) étant apte à convertir une tension d'entrée ($V_{in}$) en une tension de sortie ($V_{out}$) et comprenant une première (30) et une deuxième (32) bornes d'entrée aptes à recevoir la tension d'entrée ($V_{in}$), au moins deux bornes de sortie (34) aptes à délivrer la tension de sortie ($V_{out}$), une première branche de filtrage (36) connectée entre les bornes d'entrée (30, 32), une deuxième branche de filtrage (38) connectée en parallèle de la première branche de filtrage (36), au moins deux branches de commutation (40) connectées en parallèle de la deuxième branche de filtrage (38), chaque branche de filtrage (36, 38) comportant un condensateur (56), chaque branche de commutation (40) comportant deux demi-branches de commutation (60) connectées en série et reliées entre elles en un point intermédiaire (62), le point intermédiaire (62) de chaque branche de commutation (40) formant alors une borne de sortie (34) respective, chaque demi-branche (60) comportant au moins un interrupteur (64),

   **caractérisé en ce que** le dispositif de surveillance (20) comprend une impédance de détection (45) configurée pour être connectée entre les première (36) et deuxième (38) branches de filtrage, et un module de détection (50) configuré pour comparer la tension ($V_D$) aux bornes de l'impédance de détection (45) avec un seuil de tension prédéfini (S), puis pour générer un signal de détection dès que la tension ($V_D$) aux bornes de l'impédance de détection (45) est supérieure au seuil de tension prédéfini (S).

2. Dispositif (20) selon la revendication 1, dans lequel chaque branche de filtrage (36, 38) comporte une première extrémité (52) reliée à la première borne d'entrée (30) et une deuxième extrémité (54) reliée à la deuxième borne d'entrée (32), et

   dans lequel l'impédance de détection (45) comporte au moins une impédance parmi une première impédance (75) configurée pour être connectée entre lesdites premières extrémités (52) et une deuxième impédance configurée pour être connectée entre lesdites deuxièmes extrémités (54).

3. Dispositif (20) selon la revendication 1 ou 2, dans lequel la ou chaque impédance est une inductance ;

   l'inductance étant de préférence une inductance parasite associée à une liaison de connexion entre les première (36) et deuxième (38) branches de filtrage.

4. Dispositif (20) selon la revendication 3, dans lequel l'impédance de détection (45) présente une valeur d'inductance comprise entre 10 nH et 100 nH.

5. Dispositif (20) selon la revendication 1 ou 2, dans lequel la ou chaque impédance est une résistance.

6. Dispositif (20) selon l'une quelconque des revendications précédentes, dans lequel le module de détection (50) comporte un étage redresseur (84), un étage (86) de protection contre une surtension, un étage (90) de détection de franchissement du seuil de tension prédéfini (S), et un étage (92) de protection contre une surintensité ;

les étages redresseur (84), de protection contre une surtension (86), de détection de franchissement (90) et protection contre une surintensité (92) étant de préférence connectés successivement l'un après l'autre ; l'étage de détection de franchissement (90) étant de préférence formé d'une diode Zener (120) de tension d'amorçage égale au seuil de tension prédéfini (S).

7.  Dispositif (20) selon l'une quelconque des revendications précédentes, dans lequel le module de détection (50) comporte un optocoupleur (138) configuré pour générer le signal de détection, l'optocoupleur (138) étant relié à l'étage de détection de franchissement (90) ;

    l'étage de protection contre une surintensité (92) étant de préférence connecté entre l'étage de détection de franchissement (90) et l'optocoupleur (138).

8.  Système de conversion d'énergie électrique (5), comprenant un convertisseur d'énergie électrique (10) apte à convertir une tension d'entrée ($V_{in}$) en une tension de sortie ($V_{out}$) et un dispositif (20) de surveillance du convertisseur d'énergie électrique (10),

    le convertisseur (10) comprenant une première (30) et une deuxième (32) bornes d'entrée aptes à recevoir la tension d'entrée ($V_{in}$), au moins deux bornes de sortie (34) aptes à délivrer la tension de sortie ($V_{out}$), une première branche de filtrage (36) connectée entre les bornes d'entrée (30, 32), une deuxième branche de filtrage (38) connectée en parallèle de la première branche de filtrage (36), au moins deux branches de commutation (40) connectées en parallèle de la deuxième branche de filtrage (38), chaque branche de filtrage (36, 38) comportant un condensateur (56), chaque branche de commutation (40) comportant deux demi-branches de commutation (60) connectées en série et reliées entre elles en un point intermédiaire (62), le point intermédiaire (62) de chaque branche de commutation (40) formant alors une borne de sortie (34) respective, chaque demi-branche (60) comportant au moins un interrupteur (64),
    **caractérisé en ce que** le dispositif de surveillance (20) est selon l'une quelconque des revendications précédentes, et l'impédance de détection (45) est connectée entre les première (36) et deuxième (38) branches de filtrage.

9.  Système (5) selon la revendication 8, dans lequel chaque interrupteur (64) comporte un composant semi-conducteur de commutation, tel qu'un transistor ;

    chaque composant semi-conducteur de commutation étant de préférence réalisé en un matériau choisi parmi le groupe consistant en : nitrure de gallium (GaN), carbure de silicium (SiC) et silicium (Si) ;
    chaque composant semi-conducteur de commutation étant de préférence encore réalisé en un matériau semi-conducteur à large bande, tel que le nitrure de gallium (GaN) ou le carbure de silicium (SiC).

10. Procédé de surveillance d'un convertisseur d'énergie électrique (10), le convertisseur d'énergie électrique (10) étant apte à convertir une tension d'entrée ($V_{in}$) en une tension de sortie ($V_{out}$) et comprenant une première (30) et une deuxième (32) bornes d'entrée aptes à recevoir la tension d'entrée ($V_{in}$), au moins deux bornes de sortie (34) aptes à délivrer la tension de sortie ($V_{out}$), une première branche de filtrage (36) connectée entre les bornes d'entrée (30, 32), une deuxième branche de filtrage (38) connectée en parallèle de la première branche de filtrage (36), au moins deux branches de commutation (40) connectées en parallèle de la deuxième branche de filtrage (38), chaque branche de filtrage (36, 38) comportant un condensateur (56), chaque branche de commutation (40) comportant deux demi-branches de commutation (60) connectées en série et reliées entre elles en un point intermédiaire (62), le point intermédiaire (62) de chaque branche de commutation (40) formant alors une borne de sortie (34) respective, chaque demi-branche (60) comportant au moins un interrupteur (64),
    le procédé étant **caractérisé en ce qu'**il comprend les étapes suivantes :

    - connexion (200) d'une impédance de détection (45) entre les première (36) et deuxième (38) branches de filtrage ;
    - comparaison (210) de la tension ($V_D$) aux bornes de l'impédance de détection (45) avec un seuil de tension prédéfini (S) ; et
    - génération (220) d'un signal de détection dès que la tension ($V_D$) aux bornes de l'impédance de détection (45) est supérieure au seuil de tension prédéfini (S).

11. Utilisation d'un dispositif électronique de surveillance (20) pour surveiller un convertisseur d'énergie électrique (10), le convertisseur d'énergie électrique (10) étant apte à convertir une tension d'entrée ($V_{in}$) en une tension de sortie ($V_{out}$) et comprenant une première (30) et une deuxième (32) bornes d'entrée aptes à recevoir la tension d'entrée

($V_{in}$), au moins deux bornes de sortie (34) aptes à délivrer la tension de sortie ($V_{out}$), une première branche de filtrage (36) connectée entre les bornes d'entrée (30, 32), une deuxième branche de filtrage (38) connectée en parallèle de la première branche de filtrage (36), au moins deux branches de commutation (40) connectées en parallèle de la deuxième branche de filtrage (38), chaque branche de filtrage (36, 38) comportant un condensateur (56), chaque branche de commutation (40) comportant deux demi-branches de commutation (60) connectées en série et reliées entre elles en un point intermédiaire (62), le point intermédiaire (62) de chaque branche de commutation (40) formant alors une borne de sortie (34) respective, chaque demi-branche (60) comportant au moins un interrupteur (64),

**caractérisé en ce que**, lors de son utilisation, le dispositif de surveillance (20) comprend une impédance de détection (45) connectée entre les première (36) et deuxième (38) branches de filtrage, et un module de détection (50) configuré pour comparer la tension ($V_D$) aux bornes de l'impédance de détection (45) avec un seuil de tension prédéfini (S), puis pour générer un signal de détection dès que la tension ($V_D$) aux bornes de l'impédance de détection (45) est supérieure au seuil de tension prédéfini (S).

FIG.1

EP 4 199 345 A1

FIG.2

EP 4 199 345 A1

Connexion d'une impédance de détection entre des première et deuxième branches de filtrage ⌐ 200

Comparaison de la tension aux bornes de l'impédance de détection avec un seuil de tension prédéfini ⌐ 210

Génération d'un signal de détection dès que la tension aux bornes de l'impédance de détection est supérieure au seuil de tension prédéfini ⌐ 220

## FIG.3

FIG.4

FIG.5

FIG.6

Europäisches
Patentamt

European
Patent Office

Office européen
des brevets

# RAPPORT DE RECHERCHE EUROPEENNE

Numéro de la demande

EP 22 21 3560

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | US 2019/146020 A1 (BANERJI SUDEEP [US] ET AL) 16 mai 2019 (2019-05-16) | 1-7 | INV.<br>H02P27/06 |
| A | * alinéa [0018] – alinéa [0040]; figures 1-7 * | 8-11 | H02M7/42<br>H02M1/00<br>G01R31/42 |
| | ----- | | G01R19/00 |
| X,D | Person Jonas ET AL: "Short Circuit Detection Methods for Silicon Carbide (SiC) Power Semiconductors", PCIM Europe 2019, 9 mai 2019 (2019-05-09), pages 217-223, XP055946816, ISBN: 978-3-8007-4938-6 Extrait de l'Internet: URL:https://ieeexplore.ieee.org/stampPDF/g etPDF.jsp?tp=&arnumber=8767500&ref=aHR0cHM 6Ly93d3cuZ29vZ2xlLmNvbS8= [extrait le 2022-07-27] * page 218 – page 219; figure 3 * | 1 | H02M1/32<br>G01R19/165<br>G01R19/12<br>H02M7/5387<br><br>ADD.<br>G01R1/20 |
| | ----- | | |
| A | US 10 158 291 B1 (CINAGROSSI NICOLA [CH] ET AL) 18 décembre 2018 (2018-12-18) * abrégé; figure 2 * | 1-11 | DOMAINES TECHNIQUES RECHERCHES (IPC) |
| | ----- | | H02P |
| A | LAUMEN MICHAEL ET AL: "Ultra-Fast Short-Circuit Detection for SiC-MOSFETs Using DC-Link Voltage Monitoring", 2020 IEEE 11TH INTERNATIONAL SYMPOSIUM ON POWER ELECTRONICS FOR DISTRIBUTED GENERATION SYSTEMS (PEDG), IEEE, 28 septembre 2020 (2020-09-28), pages 547-553, XP033854241, DOI: 10.1109/PEDG48541.2020.9244367 * le document en entier * | 1-11 | H02M<br>G01R |
| | ----- | | |
| | -/-- | | |

Le présent rapport a été établi pour toutes les revendications

| Lieu de la recherche | Date d'achèvement de la recherche | Examinateur |
|---|---|---|
| Munich | 24 avril 2023 | Hijazi, Ali |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
...................................................................
& : membre de la même famille, document correspondant

EPO FORM 1503 03.82 (P04C02)

Europäisches
Patentamt

European
Patent Office

Office européen
des brevets

## RAPPORT DE RECHERCHE EUROPEENNE

Numéro de la demande

EP 22 21 3560

| | DOCUMENTS CONSIDERES COMME PERTINENTS | | |
|---|---|---|---|
| Catégorie | Citation du document avec indication, en cas de besoin, des parties pertinentes | Revendication concernée | CLASSEMENT DE LA DEMANDE (IPC) |
| A | OINONEN MARKUS ET AL: "Current measurement and short-circuit protection of an IGBT based on module parasitics", 2014 16TH EUROPEAN CONFERENCE ON POWER ELECTRONICS AND APPLICATIONS, IEEE, 26 août 2014 (2014-08-26), pages 1-9, XP032651268, DOI: 10.1109/EPE.2014.6910824 * le document en entier * ----- | 1-11 | |
| A | EP 2 899 886 A1 (HITACHI LTD [JP]) 29 juillet 2015 (2015-07-29) * abrégé; figures 1-4 * ----- | 1-11 | |
| | | | DOMAINES TECHNIQUES RECHERCHES (IPC) |

Le présent rapport a été établi pour toutes les revendications

| Lieu de la recherche | Date d'achèvement de la recherche | Examinateur |
|---|---|---|
| Munich | 24 avril 2023 | Hijazi, Ali |

CATEGORIE DES DOCUMENTS CITES

X : particulièrement pertinent à lui seul
Y : particulièrement pertinent en combinaison avec un
    autre document de la même catégorie
A : arrière-plan technologique
O : divulgation non-écrite
P : document intercalaire

T : théorie ou principe à la base de l'invention
E : document de brevet antérieur, mais publié à la
    date de dépôt ou après cette date
D : cité dans la demande
L : cité pour d'autres raisons

& : membre de la même famille, document correspondant

EPO FORM 1503 03.82 (P04C02)

page 2 de 2

## ANNEXE AU RAPPORT DE RECHERCHE EUROPEENNE
## RELATIF A LA DEMANDE DE BREVET EUROPEEN NO.

EP 22 21 3560

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

24-04-2023

| Document brevet cité au rapport de recherche | | Date de publication | Membre(s) de la famille de brevet(s) | | | Date de publication |
|---|---|---|---|---|---|---|
| US 2019146020 | A1 | 16-05-2019 | US | 2019146020 | A1 | 16-05-2019 |
| | | | US | 2019277897 | A1 | 12-09-2019 |
| | | | US | 2020333390 | A1 | 22-10-2020 |
| US 10158291 | B1 | 18-12-2018 | AUCUN | | | |
| EP 2899886 | A1 | 29-07-2015 | CN | 104795973 | A | 22-07-2015 |
| | | | EP | 2899886 | A1 | 29-07-2015 |
| | | | JP | 6190280 | B2 | 30-08-2017 |
| | | | JP | 2015139271 | A | 30-07-2015 |

Pour tout renseignement concernant cette annexe : voir Journal Officiel de l'Office européen des brevets, No.12/82

EPO FORM P0460

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **S. HAIN.** *New Ultra Fast Short Circuit Detection Method Without Using the Desaturation Process of the Power Semiconductor*

- **DE J. PERSON.** *Short Circuit Detection Methods for Silicon Carbide (SiC) Power Semiconductors*